(19) Europäisches Patentamt
European Patent Office
Office européen des brevets

(11) **EP 1 118 095 B1**

(12) **EUROPÄISCHE PATENTSCHRIFT**

(45) Veröffentlichungstag und Bekanntmachung des Hinweises auf die Patenterteilung:
**25.02.2015 Patentblatt 2015/09**

(21) Anmeldenummer: **99939301.0**

(22) Anmeldetag: **30.08.1999**

(51) Int Cl.:
***H01J 37/32*** *(2006.01)*

(86) Internationale Anmeldenummer:
**PCT/CH1999/000399**

(87) Internationale Veröffentlichungsnummer:
**WO 2000/019483 (06.04.2000 Gazette 2000/14)**

(54) **VAKUUMBEHANDLUNGSKAMMER UND VERFAHREN ZUR OBERFLÄCHENBEHANDLUNG**

VACUUM TREATMENT CHAMBER AND METHOD FOR TREATING SURFACES

CHAMBRE DE TRAITEMENT SOUS VIDE ET PROCEDE DE TRAITEMENT DE SURFACE

(84) Benannte Vertragsstaaten:
**AT BE CH CY DE DK ES FI FR GB IE IT LI NL SE**

(30) Priorität: **30.09.1998 CH 198698**

(43) Veröffentlichungstag der Anmeldung:
**25.07.2001 Patentblatt 2001/30**

(73) Patentinhaber: **Oerlikon Advanced Technologies AG**
**9496 Balzers (LI)**

(72) Erfinder: **WEICHART, Jürgen**
**FL-9496 Balzers (LI)**

(74) Vertreter: **Troesch Scheidegger Werner AG**
**Schwäntenmos 14**
**8126 Zumikon (CH)**

(56) Entgegenhaltungen:
EP-A- 0 782 172    EP-A- 0 801 413
WO-A-96/13051    WO-A-99/03313
US-A- 5 234 529    US-A- 5 449 433

EP 1 118 095 B1

**Beschreibung**

Die vorliegende Erfindung betrifft eine Vakuumbehandlungskammer nach dem Oberbegriff von Anspruch 1 sowie ein Verfahren an Oberflächenbehandlung nach demjenigen von Anspruch 9.

Es ist bekannt, dass in Vakuumbehandlungskammern für Werkstücke Plasmen induktiv und/oder kapazitiv erzeugt werden können.

Bei der kapazitiven Plasmaerzeugung werden in der Vakuumkammer vorgesehene Elektroden auf unterschiedliche elektrische Potentiale gelegt, wie beispielsweise DC- oder HF-Potentiale, und damit zwischen den Elektroden ein elektrisches Feld, ähnlich demjenigen eines Kondensators, mit dem Vakuum als Dielektrikum, erzeugt.

Bei der induktiven Plasmaerzeugung wird mindestens eine Induktionsspule vorgesehen, welche den Plasmaentladungsraum umschliesst, und es wird in der Kammer ein Induktionsfeld erzeugt.

Des öfteren wird, wie erwähnt, das Plasma kombiniert kapazitiv und induktiv angeregt, teilweise auch bei geschalteten Plasmen, bei denen praktisch ein "Stand-by-Plasma" induktiv erzeugt wird und die kapazitiv eingekoppelte Leistung an- und abgeschaltet wird.

Zur induktiven Einkopplung des Induktionsfeldes in den Entladungsraum kann die Induktionsspule wohl gegen den Entladungsraum freiliegen, wird aber bevorzugt von letzterem durch eine dielektrische Wandung getrennt, ist dann bezüglich der Vakuumkammer meistens aussenliegend angeordnet, oder ist gegebenenfalls in das Material der dielektrischen Wandung eingebettet. Eine Vakuumbehandlungskammer, bei welcher sowohl kapazititive wie auch induktive Plasmaerzeugung kombiniert eingesetzt werden, ist beispielsweise aus der EP-0 271 341 bekannt.

Werden nun in einer Kammer, bei der ein Plasma induktiv mindestens miterzeugt wird, elektrisch leitende Teilchen freigesetzt, wie z.B. beim Sputterätzen elektrisch leitender Werkstückoberflächen oder beim Sputterbeschichten von Werkstücken mit elektrisch leitenden Schichten oder bei PECVD-Verfahren, bei denen elektrisch leitende Partikel erzeugt werden, so entstehen folgende Probleme:

• Ist die Induktionsspule innerhalb der Kammer dem Entladungsraum frei ausgesetzt, so erfolgt eine Störbeschichtung der Induktionsspule. Dies führt mit zunehmender Prozessdauer zum Abblättern von Störbeschichtungspartikeln, mit entsprechender Beeinträchtigung des Prozesses.

• Ist die Induktionsspule wie bevorzugt durch dielektrisches Material vom Entladungsraum abgetrennt, so ergibt sich eine mit zunehmender Prozessdauer zunehmend dicke Beschichtung der dielektrischen Wand mit elektrisch leitendem Material. Dadurch nimmt die induktiv in den Entladungsraum eingekoppelte Leistung ab und wird zunehmend in der elektrisch leitenden Störbeschichtung in Wärme umgesetzt.

Auf diese genannten Probleme an einer Sputterbehandlungskammer mit kapazitiver Hochfrequenz und induktiver Plasmaerregung, mittels einer ausserhalb einer dielektrischen Wandung angeordneten Induktionsspule, ist in der US-A-5 569 363 eingegangen. Zur Lösung des Problems, dass die dielektrische Innenwandung mit elektrisch leitendem Material störbeschichtet wird, wird hier vorgeschlagen, zwischen Entladungsraum und dielektrischer Wandung der Kammer einen zylindrischen Stahlschirm vorzusehen mit einer Dicke von ca. 0,1 mm. Der Schirm ist, parallel zur Achse der Induktionsspule, durchgehend aufgeschlitzt. Aufgrund dieses Längsschlitzes können im metallischen Zylinderschirm keine umlaufenden Kreisströme mehr entstehen, ihre Bahn ist durch den Schlitz unterbrochen. Auch bei Ablagerung elektrisch leitender Schichten auf der Innenseite des Zylinders bleibt dieser Unterbruch bestehen. Dabei wird die dielektrische Wand durch den Schirm vor elektrisch leitender Beschichtung geschützt. Nachteilig an diesem Vorgehen ist, dass die induktive Leistungseinkopplung durch Vorsehen eines solchen leitenden Schirmes deutlich reduziert wird.

Aus der EP-A-0 782 172 eine Vakuumbehandlungskammer bekannt, bei der, wiederum kombiniert, durch DC-Betrieb eines Targets kapazitiv sowie durch HF-Betrieb einer Induktionsspule induktiv ein Plasma zur Sputterbehandlung von Werkstücken erzeugt wird. Die Induktionsspule liegt bei der einen Ausführungsform innerhalb des Vakuumrezipienten, bei der anderen eingebettet in eine dielektrische Wandung. Jedenfalls ist zwischen dem Entladungsraum und der Induktionsspule mindestens eine zylindrische Schirm-Anordnung vorgesehen, die aus dielektrischem oder metallischem Material gefertigt ist. Die Schirmanordnung hat achsparallele Schlitze welche Durchsicht vom Entladungsraum hin gegen die Spule blockieren. Die Vakuumbehandlungskammer nach der EP 0 801 413 weist alle Merkmale des Oberbegriffs von Anspruch 1 auf und hat, ähnlich derjenigen aus der EP-A-0 782 172, eine Schild-Anordnung auf mit Durchsicht versperrenden Schlitzen.

Es wird gemäss der US-A-5 569 363 und der EP-A-0 782 172 davon ausgegangen, dass, unabhängig, ob die geschlitzte Schild-Anordnung aus einem metallischen oder dielektrischen Material gefertigt ist, die elektrisch leitende Störbeschichtung auf der Anordnung aufgefangen wird, woran bereits ein Schlitz das Entstehen von Kreisströmen in der leitenden Störbeschichtung verhindert, mehrere gleich verteilte Schlitze jedoch offenbar die Entladungsverhältnisse besser symmetrisieren. Um gänzlich zu verhindern, dass elektrisch leitende Störbeschichtung sich durch die Schlitze eines Schildes an die Induktionsspule bzw. die dielektrische Wandung niedersetzt, wird, gemäss der EP-A 0 782 172, an der Schildanordnung ein zweiter koaxialer Schirm vorgesehen, gleich ausgebildet wie der ersterwähnte, jedoch mit diesbezüglich winkelversetzten Schlitzen, so dass die Schlitze der Schild-Anordnung Durchsicht blockieren. Aus der US-A 5 234 529 sowie der JP 07-153 748 sind Vakuumbehandlungsanlagen bekannt, jeweils mit zwischen Spule und einer, einen Entladungsraum umschiessenden Wandung eingebautem, axial geschlitzten Schirm.

Es kann darauf hingewiesen werden, dass, unabhängig, ob der Schirm aus dielektrischem Material oder aus Metall gefertigt ist, seine dem Entladungsraum zugewandte Fläche durch elektrisch leitende Störbeschichtung elektrisch leitend wird.

Ausgehend von einer Vakuumbehandlungskammer gemäss der EP 0 782 172 oder der EP 0 801 413 ist es Aufgabe der vorliegenden Erfindung, die Reduktion der bei elektrischer Störbeichtung des Schirmes in den Entladungsraum induktiv eingekoppelten Leistung massgeblich zu verringern und dabei eine Schutzwirkung bezüglichder Störbeschichtung beizubehalten.

Dies wird bei Ausbildung der Kammer nach dem Kennzeichen von Anspruch 1 erreicht.

Vorerst unabhängig davon, ob der Schirm aus Metall oder aus dielektrischem Material gefertigt ist, geht die vorliegende Erfindung von der Erkenntnis aus, dass bei elektrisch leitender Innenoberfläche des Schirmes - jedenfalls bei elektrisch leitender Störbeschichtung - die Verluste induktiv eingekoppelter Leistung massgeblich durch Wirbelströme erzeugt werden, und nicht - wenigstens nicht allein - durch Kreisströme, wie insbesondere gemäss der US-A-5 569 369 ausgeführt. Erfindungsgemäss wird mithin der Schirm mit hoher Schlitzdichte versehen, was sich nur an einem in sich geschlossenen Körper handhabungsfreundlich realisieren lässt, womit zusätzlich auch die Aufgabe des schnellen Schirmauswechselns gelöst ist.

Erfindungsgemäß wird die Schlitzdichte (Anzahl Schlitze pro cm) zu

$1 \leq S$, vorzugsweise gar zu

$1{,}5 \leq S$ gewählt,

vorzugsweise bei Schlitzbreiten d von vorzugsweise

$d \leq 2$ mm, vorzugsweise $d \leq 1$ mm.

Die obere Grenze der Schlitzdichte ergibt sich aus Grenzen der Schlitzfertigung und einzuhaltenden Schlitzminimalbreiten um, nach Massgabe von Standzeitüberlegungen, Zuwachsen der Schlitze durch Störbeschichtung, abhängig vom jeweiligen Störbeschichtungsmaterial, nicht zu rasch erfolgen zu lassen.

In einer bevorzugten Ausführungsform ist der erfindungsgemäss ausgebildete Schirm aus einem Metall gefertigt und bevorzugt auf ein Bezugspotential, wie z.B. auf Massepotential, gelegt. Dies hat - gegenüber einem dielektrischen Schirm - u.a. den wesentlichen Vorteil, dass aufgrund der aufwachsenden elektrisch leitenden Störbeschichtung keine signifikante Änderung der induktiv eingekoppelten Leistung mehr entsteht, so dass sich die voreingestellte Plasmadichte entsprechend der induktiv eingekoppelten Leistung aufgrund der aufwachsenden Störbeschichtung kaum mehr ändert. Sind die Schlitze in Aufsicht, d.h. in Richtung der Spulenachse betrachtet, bezüglich Radialrichtung verkippt, so wird die Schutzwirkung des Schirmes gegen durchtretende Störbeschichtung noch weiter erhöht.

In einer besonders bevorzugten Ausführungsform weist die Kammer eine koaxiale Wandung aus dielektrischem Material auf. Erfindungsgemäß liegt der Schirm innerhalb dieser Wandung, und die Induktionsspule ist in oder ausserhalb dieser Wandung angeordnet.

In einer weiteren bevorzugten Ausführungsform ist in der Kammer mindestens ein Elektrodenpaar vorgesehen, wobei dieses an eine DC-Quelle, eine AC-Quelle, eine AC+DC-Quelle, eine pulsierende DC-Quelle, bevorzugt an eine HF- oder DC-Quelle geschaltet ist. Dabei wird das Betriebsplasma mittels der Spule induktiv und mittels des Elektrodenpaares kapazitiv angeregt. Als Elektrode bzw. Elektrodenpaar kann dabei eine Sputterquelle, wie beispielsweise eine Magnetronquelle, oder ein Substratträger eingesetzt sein. Bevorzugt wird die Induktionsspule mit einem Mittelfrequenzgenerator betrieben, arbeitend auf einer Mittelfrequenz $f_m$ :

$$100 \text{ kHz} \leq f_m \leq 800 \text{ kHz},$$

vorzugsweise auf $f_m$ = ca. 400 kHz.

Auch wenn der erfindungsgemäss vorgesehene, eng geschlitzte Schirm, dessen Schlitze nicht zwingend achsparallel verlaufen müssen, sondern auch diesbezüglich schiefwinklig angeordnet sein können, aus Metall gebildet ist, ergibt sich je nach Störbeschichtungsmaterial beim Aufwachsen der Störbeschichtung eine Änderung der induktiv eingekoppelten Leistung. Weit ausgesprochener ist dies der Fall, wenn der erfindungsgemäss vorgesehene Schirm aus dielektrischem Material gefertigt ist. Um diesen Problemen jedenfalls entgegenzuwirken und die Plasmabetriebsverhältnisse möglichst konstant oder mindestens mit zeitlich gewollter Änderung zu führen, wird an einer bevorzugten Ausführungsform der erfindungsgemässen Behandlungskammer eine Messanordnung für die Plasmadichte vorgesehen, vorzugsweise eine Spannungsmessanordnung an einer Elektrode, wie beispielsweise an einem Werkstückträger oder an einem Sputtertarget, deren Ausgangssignal als gemessener IST-Wert einem Regelkreis zugeführt ist, welcher auf einen Generator für die Induktionsspule, als Stellglied für die Plasmadichte, wirkt.

In einer weiteren Ausführungsform kann mit dem erfindungsgemäss geschlitzten Schirm innerhalb der Vakuumkammer der Entladungsraum von einem radial aussengelegenen Ringraum abgetrennt sein, in welchen eine Gasleitungsanordnung einmündet. Mithin wird in diesem Fall der Schirm mit seinen Schlitzen gleichzeitig zur Gaseindüsung in den Entladungsraum ausgenützt, bildet eine Schlitzringdüsenanordnung. Bei Reaktivprozessen wird dabei bevorzugterweise das inerte Arbeitsgas, wie beispielsweise Argon, durch den erwähnten Schirm eingedüst, womit zusätzlich die Schichtbeaufschlagung mit elektrisch leitender Störbeschichtung verzögert wird.

Das erfindungsgemässe Verfahren lässt sich weiter insbesondere für Sputterätzen von metallischen Schichten, Sputterbeschichten von Werkstücken, wie z. B. von Thin Film Heads fürs Magnetronsputtern einsetzen. Wie erwähnt, kann es aber auch für weitere plasmaunterstützte Behandlungsverfahren eingesetzt werden, bei denen das Plasma induktiv mindestens mitangeregt wird, wie für PECVD-Verfahren, reaktive Sputterverfahren, seien dies Sputterbeschichtungs- oder Sputterätzverfahren.

Die Erfindung wird anschliessend beispielsweise anhand von Figuren erläutert. Es zeigen:

Fig: 1    schematisch, eine Vakuumbehandlungskammer mit induktiver Plasmaanregung zur Erläuterung der der vorliegenden Erfindung zugrundeliegenden Probleme,

Fig. 2    bei Vorsehen eines metallischen oder dielektrischen, zylindrisch in sich geschlossenen Schirmes an der Kammer gemäss Fig. 1, das Entstehen von Kreisströmen sowie deren Unterbindung nach dem Stand der Technik, weiter dadurch nicht unterbundende induzierte Wirbelströme,

Fig. 3    schematisch, den an einer erfindungsgemässen Vakuumkammer für eine erfindungsgemässe Werkstückbehandlung eingesetzte Schirm,

Fig. 4    eine bevorzugte Ausbildung der am Schirm gemäss Fig. 3 vorgesehenen Schlitze,

Fig. 5    schematisch, eine erste erfindungsgemässe Ausführungsform der Vakuumbehandlungskammer mit innerhalb der Kammer angeordneter Induktionsspule,

Fig. 6    in Darstellung analog zu Fig. 5, eine erfindungsgemässe Kammer mit ausserhalb gelegener Induktionsspule, und

Fig. 7    schematisch, eine weitere erfindungsgemässe und bevorzugte Ausführungsform der erfindungsgemässen Vakuumbehandlungskammer, in Darstellung analog zu den Fig. 5 und 6, zum Sputterätzen oder Sputterbeschichten von Werkstücken.

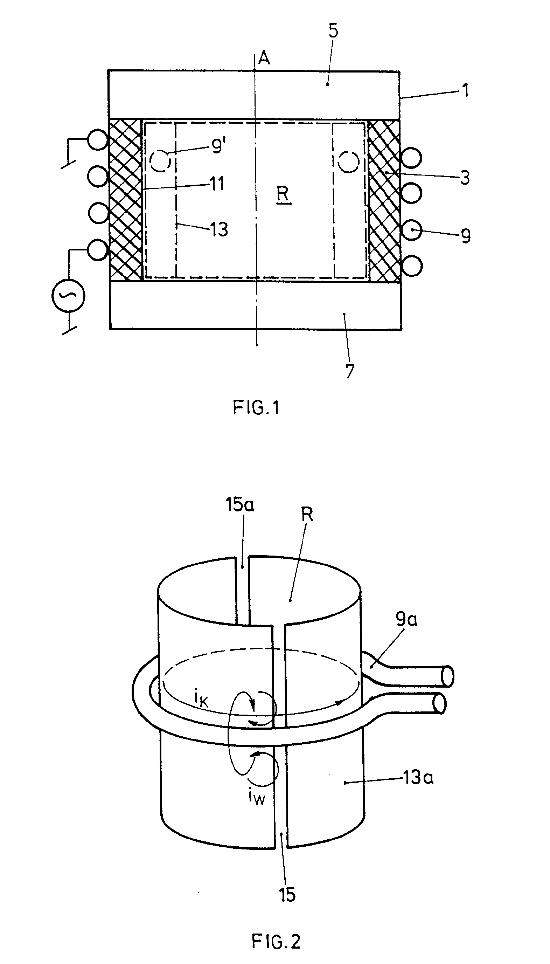

In Fig. 1 ist eine Vakuumkammer 1 schematisch dargestellt, welche eine zylindrische dielektrische Wand 3 mit stirnseitigen metallischen Abschlüssen 5 und 7 aufweist. Einerseits besteht die Wand 3 aus dielektrischem Material, um bei Elektrodenbetrieb der Stirnwände 5 und 7, für kapazitive Plasmaanregung, diese - 5,7 - elektrisch voneinander zu trennen, anderseits damit eine ausserhalb der Kammer 1 gelegene Induktionsspule 9 mit Achse A induktiv Leistung in den Entladungsraum R einkoppeln kann. Werden nun bei einer Werkstückbehandlung, welcher Art auch immer, im Entladungsraum R elektrisch leitende Teilchen freigesetzt, wie dies der Fall ist z.B. beim Sputterätzen leitender Oberflächen, bei Sputterbeschichten mit leitenden Schichten, aber auch bei PECVD-Verfahren, plasmaunterstützten reaktiven Ätz- bzw. Beschichtungsverfahren auftreten kann, so wird die Innenverkleidung, insbesondere auch die Innenfläche der dielektrischen Wandung 3, elektrisch leitend - wie schematisch bei 11 dargestellt - beschichtet. Damit ändert sich mit zunehmender Schichtdicke die induktiv in den Entladungsraum R eingekoppelte Leistung.

Ist die Induktionsspule ausnahmsweise und wie gestrichelt bei 9' angedeutet innerhalb der Vakuumkammer angeordnet und frei dem Entladungsraum R ausgesetzt, eine Anordnung, bei der dielektrische Abstandshalter gemäss der Wandung 3 nurmehr zur elektrischen Trennung - gegebenenfalls als Elektroden eingesetzter Platten 5 und 7 - eingesetzt wird, so wird die Spule 9' mit der elektrisch leitenden Störbeschichtung beaufschlagt, eine Beschichtung, die schliesslich abblättern wird und den Behandlungsprozess kontaminiert.

Um diese Probleme zu beheben, ist es bekannt, wie eingangs erwähnt wurde, zwischen Entladungsraum R und Induktionsspule 9' bzw. dielektrische Wand 3 eine Schirmanordnung 13 vorzusehen. Diese soll einerseits die negativen Auswirkungen elektrisch leitender Störbeschichtung auf die induktive Leistungseinkopplung in den Entladungsraum R reduzieren, trotzdem aber eine grösstmögliche induktive Leistungseinkopplung gewährleisten.

In Fig. 2 ist schematisch eine Induktionsspule 9a gemäss 9 von Fig. 1 dargestellt, welche einen mindestens aufgrund der Störbeschichtung gemäss Fig. 1 elektrisch leitenden Schirm 13a umschliesst. Aufgrund der Induktionswirkung entstehen vorab am geschlossenen Zylinder Kreisströme $i_K$ in der in Fig. 2 schematisiert dargestellten Art. Zudem entstehen - wie dargestellt - Wirbelströme $i_w$, deren Auswirkungen, wie erfindungsgemäss erkannt wurde, keinesfalls vernachlässigbar sind. Gemäss vorbekannten Ansätzen werden durch Aufschlitzen des Schirmes 13a, wie in Fig. 2 dargestellt bei 15, 15a, die Kreisströme unterbunden und der Durchgriff der Induktionsleistung in den Entladungsraum R möglichst aufrechterhalten; dies durch Ausbildung des Schirmes 13a aus dielektrischem Material oder Vorsehen mehrerer verteilter, relativ breiter Schlitze 15 bzw. 15a.

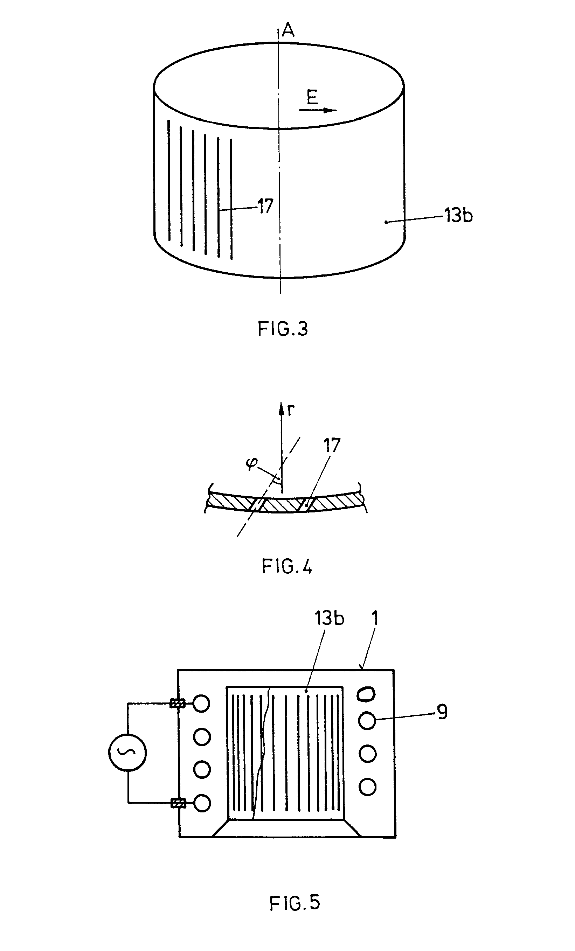

In Fig. 3 ist nun ein erfindungsgemässer Schirm 13b dargestellt, wie er an einer erfindungsgemässen Kammer, wie - abgesehen vom Schirm - grundsätzlich in Fig. 1 dargestellt, eingesetzt wird. Der Schirm 13b ist als in sich geschlossener Körper ausgebildet, beispielsweise als Zylinderschirm. Seine Mantelfläche ist mit Schlitzen 17 in dichter Abfolge geschlitzt. Die Schlitze verlaufen, mindestens in einer Ausrichtungskomponente, parallel zur Achse A des Schirmes, vorzugsweise wie dargestellt achsparallel. Bezogen auf eine Längeneinheit E in Umfangsrichtung des Schirmes 13b beträgt die Dichte der Schlitze 17 "Anzahl Schlitze pro cm" mindestens 1, vorzugsweise gar mindestens 1,5.

Durch die hohe Schlitzdichte wird das Entstehen von Wirbelströmen $i_w$ am erfindungsgemässen Schirm 13b nachhaltig reduziert, sei dies am bevorzugt aus einem Metall, wie Aluminium, gefertigten Schirm, oder sei dies an einem aus dielektrischem Material gefertigten, nachmals elektrisch leitend störbeschichteten Schirm.

Die Schlitze 17 werden mit einer bevorzugten Breite d von höchstens 2 mm, vorzugsweise von höchstens 1 mm, beispielsweise durch Wasserstrahlschneiden realisiert. Wie in Fig. 4, betrachtet in Richtung der Achse A, an einem Querschnitt des Schirmes nach Fig. 3 ersichtlich, sind die Schlitze 17 bezogen auf die radiale Richtung r erfindungsgemäß um φ geneigt, was zusätzlich die Schutzwirkung des Schirmes bezüglich Austreten von Partikeln aus dem Entladungsraum R erhöht.

Bevorzugt beträgt φ zwischen 30° und 40° bezüglich Radialrichtung r.

Wie erwähnt, wird der Schirm 13b bevorzugterweise aus Metall gefertigt, was ermöglicht, ihn in der erfindungsgemässen Kammer auf ein Bezugspotential gefesselt zu betreiben.

Aufgrund der hohen Schlitzdichte S primär wird der erfindungsgemäss eingesetzte Schirm aus einem integralen Teil gebildet, was gleichzeitig die Handhabung wesentlich erleichtert, wenn der Schirm an einer erfindungsgemässen Kammer ersetzt werden muss. Damit werden deren Standzeiten wesentlich reduziert.

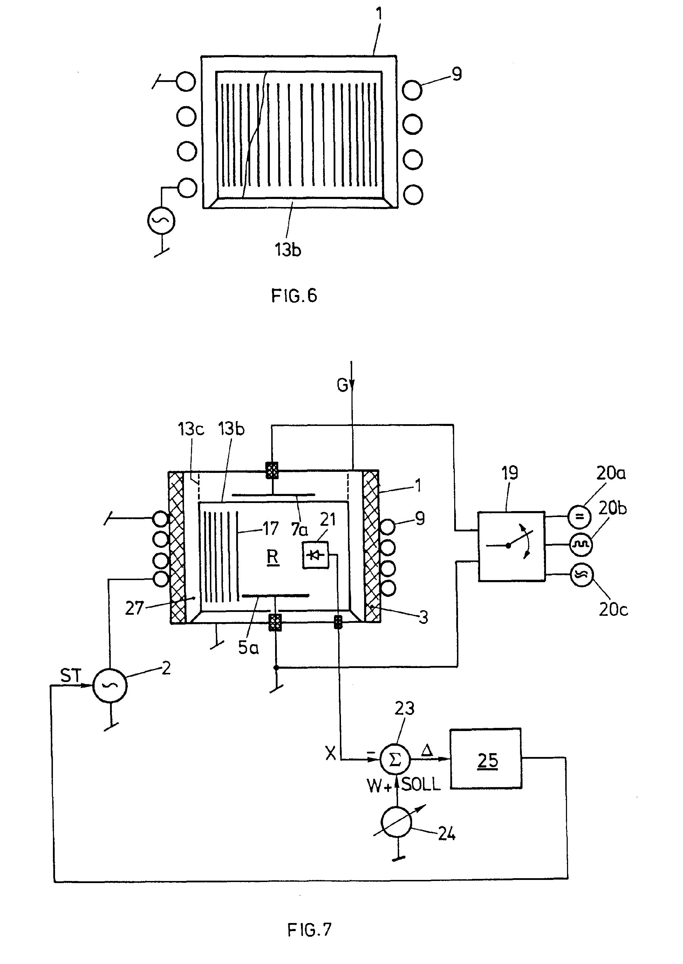

Wie sich aus der schematischen Darstellung von Fig. 5 bzw. von Fig. 6 ohne weiteres ergibt, kann an der erfindungsgemässen Behandlungskammer 1 mit dem anhand der Fig. 3 und 4 erläuterten Schirm 13b die Induktionsspule 9 innerhalb oder - wie gemäss Fig. 1 - ausserhalb der Kammer vorgesehen sein. Eine erfindungsgemässe Kammer bzw. das erfindungsgemässe Behandlungsverfahren wird immer dort eingesetzt, wo im Rahmen des Vakuumbehandlungsprozesses mit induktiv mindestens miterzeugtem Plasma elektrisch leitende Störbeschichtung entsteht.

In Fig. 7 ist, wiederum schematisch, eine bevorzugte Ausführungsvariante einer erfindungsgemässen Kammer zur erfindungsgemässen Werkstückbehandlung dargestellt. Es sind dieselben Bezugszeichen verwendet für Teile, die bereits anhand der Fig. 1 bis 6 erläutert wurden. Das Plasma im Entladungsraum R der Kammer 1 wird sowohl induktiv, mittels der Induktionsspule 9, wie auch kapazitiv, mittels mindestens eines Elektrodenpaares 7a, 5a, erzeugt. Zur kapazitiven Plasmaerzeugung kann, wie mit dem Möglichkeiten-Wahlschalter 19 schematisiert dargestellt, ein DC-Generator 20a aufgeschaltet werden, wie zum reaktiven oder nicht-reaktiven DC-Sputtern - Beschichten oder Ätzen -, DC-Magnetronsputtern. Andernfalls kann ein AC+DC-Generator 20b oder ein HF-Generator 20c angelegt werden, beispielsweise für reaktives oder nicht-reaktives Hochfrequenz-Sputterätzen oder -Sputterbeschichten. Der vorzugsweise aus Metall gefertigte erfindungsgemässe Schirm 13b ist auf Bezugspotential, beispielsweise Massepotential, gelegt.

Wie weiter in Fig. 7 schematisch dargestellt, wird in einer weiteren bevorzugten Ausführungsform mittels einer Messanordnung 21 die Plasmadichte im Raum R gemessen und das Messresultat X als gemessener IST-Wert einer Differenzbildungseinheit 23 zugeschaltet. Diese vergleicht den momentanen IST-Wert mit einem an einer Stelleinheit 24 vorgegebenen SOLL-Wert oder SOLL-Wert-Verlauf W. Als Regeldifferenz Δ wird das Vergleichsresultat über einen Regler 25 auf mindestens einen Stelleingang ST an den die Induktionsspule 9 speisenden Generator 2 gelegt, als Stellglied für die Plasmadichte im dargestellten Plasmadichte-Regelkreis. Bevorzugterweise arbeitet der Generator 2 wie erwähnt im Mittenfrequenzbereich zwischen 100 und 800 kHz, vorzugsweise im 400 kHz-Bereich.

Beispielsweise beim HF-Sputterätzen wird als Messeinrichtung 21 eine Spannungsmesseinrichtung vorgesehen, welche die Bias-Spannung an den Substraten misst bzw. an einem Substratträger, während beim HF-Sputterbeschichten, analog, die Bias-Spannung targetseitig als IST-Wert-Indikation gemessen wird.

Wird, wie in Fig. 7 bei 13c schematisch und gestrichelt dargestellt, der Entladungsraum R durch den Schirm 13b, c von einem Aussenraum 27 abgetrennt, so ist es ohne weiteres möglich, den Schirm 13b, c gleichzeitig als Verteildüse, insbesondere für Arbeitsgas, einzusetzen. Dann wird Gas G in den erwähnten Aussenraum 27 eingelassen. Insbesondere wenn in der erfindungsgemässen Kammer 1 ein reaktiver, plasmaunterstützter Prozess durchgeführt wird, kann mit Eindüsen von inertem Arbeitsgas, wie Argon, durch die Schirmschlitze 17 zusätzlich eine Störbeschichtung des Schirmes insbesondere im Schlitzbereich verlangsamt werden. Ein Reaktivgas, wie z.B. Sauerstoff oder ein anderes abscheidendes Gas, wird dann bevorzugt in der Nähe des Substrates, z.B. über eine Ringleitung, zugeführt.

Mit einer wie in Fig. 7 dargestellten erfindungsgemässen Kammer mit Schirm 13b, betrieben als Hf-Sputterkammer, wurden bei unterschiedlichen Arbeitsdrucken im Entladungsraum R und bei mehrere zehn Stunden durchgehendem Betrieb, bei Sputtern von Metallen, Abnahmen der eingekoppelten induktiven Leistung, druckabhängig, von höchstens 10 % realisiert. Mit Hilfe des anhand von Fig. 7 erläuterten Regelkreises wurde dabei der Prozess-Arbeitspunkt zusätzlich durch Nachführen der induktiven Generatorleistung stabilisiert.

Mit dem erfindungsgemässen Vorgehen, wie bevorzugt in Fig. 7 dargestellt, ist es möglich, DC-Dioden zu sputtern, d.h. mittels zweier (Di-)Elektroden 5a, 7a im DC-Betrieb und ohne Einsatz eines Magnetfeldes. Es ergeben sich mit der induktiv/kapazitiv-kombinierten Plasma-Erzeugung hohe Raten ohne störende magnetische Streufelder und unter ausgezeichneter Targetausnützung.

**Patentansprüche**

1. Vakuumbehandlungskammer (1) für Werkstücke, mit mindestens einer Induktionsspule (9, 9a, 9') mindestens zur Miterzeugung eines Behandlungsplasmas in einem innerhalb der Spule gelegenen Entladungsraum (R) sowie mit einem, dem Entladungsraum (R) unmittelbar ausgesetzten, zur Achse der Spule koaxialen, geschlitzten Schirm (13) zwischen Entladungsraum (R) und Spule (9, 9a, 9'), dessen Schlitze eine zur Spulenachse (A) parallele Richtungskomponente aufweisen, wobei der Schirm durch einen in sich geschlossenen Körper gebildet ist, **dadurch gekennzeichnet, dass**

   - die Schlitze entlang mindestens des überwiegenden Umfangs des Körpers mit einer Schlitzdichte S; d.h. Schlitzanzahl pro cm Umfangs-Länge

$$1 \ cm^{-1} \leq S$$

   aufgebracht sind, und dass die Schlitze, in Richtung der Spulenachse betrachtet, bezüglich Radialrichtung (r) verkippt ($\varphi$) sind.

2. Vakuumbehandlungskammer nach Anspruch 1, **dadurch gekennzeichnet, dass** gilt

$$1,5 \ cm^{-1} \leq S$$

3. Vakuumbehandlungskammer nach einem der Ansprüche 1 oder 2, **dadurch gekennzeichnet, dass** für die Breite d der Schlitze gilt:

$$d \leq 2 \ mm,$$

   vorzugsweise

$$d \leq 1 \ mm.$$

4. Vakuumbehandlungskammer nach einem der Ansprüche 1 bis 3, **dadurch gekennzeichnet, dass** der Schirm aus Metall gefertigt ist und vorzugsweise die Vakuumbehandlungskammer so augelegt ist, dass der Schirm auf ein elektrisches Bezugspotential gelegt werden kann.

5. Vakuumbehandlungskammer nach einem der Ansprüche 1 bis 4, **dadurch gekennzeichnet, dass** die Kammer eine koaxiale Wandung (3) aus dielektrischem Material umfasst, die Spule (9) in oder ausserhalb dieser Wandung angeordnet ist.

6. Vakuumbehandlungskammer nach einem der Ansprüche 1 bis 5, **dadurch gekennzeichnet, dass** im Entladungsraum (R) mindestens ein Paar beabstandeter Elektroden vorgesehen ist und diese Elektrodenanordnung an

   • eine DC-Quelle (20a) oder an
   • eine AC-Quelle (20c) oder an
   • eine AC+DC-Quelle (20b) oder an
   • eine gepulste DC-Quelle (20b)
   bevorzugt an eine HF- oder eine DC-Quelle geschaltet ist, wobei das Betriebsplasma zur Werkzeugbehandlung sowohl durch die Spule (9), induktiv, wie auch durch die Elektroden (5, 7), kapazitiv, anregbar ist, wobei bevorzugterweise die Induktionsspule mit einem an die Induktionsspule angeschlossenen Mittelfrequenzgenerator (2) mit einer Frequenz $f_m$ anregbar ist, für die gilt:

$$100 \ kHz < f_m \leq 800 \ kHz.$$

7. Vakuumbehandlungskammer nach einem der Ansprüche 1 bis 6, **dadurch gekennzeichnet, dass** sie einen Generator (2) für die Spule (9), einen Regelkreis (23, 25), und eine Messanordnung (21) für die Plasmadichte beinhaltet, die Messanordnung vorzugsweise in Form einer Spannungsmessanordnung an einer Elektrode im Entladungsraum, vorzugsweise an einer Werkzeugträgerelektrode oder Targetelektrode, deren Ausgangssignal als gemessener IST-Wert (X) dem Regelkreis (23, 25) zugeführt ist, welcher auf den Generator (2) für die Spule (9), als Stellglied für die Plasmadichte, wirkt.

8. Vakuumbehandlungskammer nach einem der Ansprüche 1 bis 7, **dadurch gekennzeichnet, dass** der Schirm (13b, c) in der Vakuumbehandlungskammer (1) einen Aussenraum (27) vom Entladungsraum (R) abtrennt und eine Gasleitungsanordnung (G) in den Aussenraum (27) einmündet.

9. Verfahren zur Oberflächenbehandlung von Werkstücken mit Hilfe eines in einer Vakuumbehandlungskammer erzeugten Plasmas, welches mittels einer Spulenanordnung induktiv mindestens miterzeugt wird, und bei welchem Verfahren im Plasma elektrisch leitende Materialpartikel freigesetzt werden, wobei man das Plasma mittels einem dem Plasma unmittelbar ausgesetzten, zwischen dem Plasma und der Spulenanordnung gelegenen Schirm (13b) umschliesst, mit Schlitzen (17), die mindestens in einer Richtungskomponente axial bezüglich der Spulenachse (A) gerichtet sind,
**dadurch gekennzeichnet, dass** man die Schlitze mit einer Dichte S; d.h. Schlitzanzahl pro cm Umfangs-Länge des Schirmes vorsieht, für die gilt:

$$1 \text{ cm}^{-1} \leq S$$

und die Schlitze, in Richtung der Spulenachse betrachtet, bezüglich Radialrichtung (r) verkippt (φ) vorsieht.

10. Verfahren nach Anspruch 9, **dadurch gekennzeichnet, dass** elektrisch leitende Werkstückoberflächen sputtergeätzt werden oder Werkstücke mit elektrisch leitenden Schichten sputterbeschichtet werden.

**Claims**

1. Vacuum treatment chamber (1) for workpieces with at least one induction coil (9, 9a, 9') that at least contributes to generation of a treatment plasma in a discharge space (R) located inside the coil and with a slotted screen (13) coaxially to the axis of the coil and directly exposed to the discharge space (R) and between the discharge space (R) and the coil (9, 9a, 9'), the slots of which having a direction component parallel to the axis of the coil (A), whereby the screen is formed by a self-contained, closed body, **characterized in that**

    - the slots are provided, at least along the predominant part of the circumference of the body, with a slot-density S, i.e. number of slots per cm circumference-length of $1 \text{ cm}^{-1} \leq S$ and that the slots, viewed in direction of the axis of the coil, are tilted (φ) in relation to radial direction (r).

2. The vacuum treatment chamber according to claim 1, **characterized in that** there is valid

$$1,5 \text{ cm}^{-1} \leq S.$$

3. The vacuum treatment chamber according to claim 1 or 2, **characterized in that** the width d of the slots is:

$$d \leq 2 \text{ mm,}$$

preferably

$$d \leq 1 \text{ mm.}$$

4. The vacuum treatment chamber according to one of claims 1 to 3, **characterized in that** the screen is manufactured of metal and that the vacuum chamber is preferably configured such that the screen is operable on an electric reference potential.

5. The vacuum treatment chamber according to one of claims 1 to 4, **characterized in that** the chamber comprises a coaxial wall (3) of dielectric material, the coil (9) being arranged inside or outside of this wall.

6. The vacuum treatment chamber according to one of claims 1 to 5, **characterized in that** at least one pair of spaced apart electrodes is arranged inside the discharge space (R), the electrode arrangement being connected with
a DC-source (20a) or
an AC-source (20c) or
an AC+DC-source (20b) or
a pulsed DC-source (20b),
preferably with a HF- or DC-source, wherein the operation-plasma for tool treatment is excitable, inductively by means of the coil (9) as well as capacitively by means of the electrodes (5, 7), whereby preferably the induction coil is excitable by means of a medium-frequency generator (2) with a frequency $f_m$ for which there is valid

$$100 \text{ kHz} < f_m \leq 800 \text{ kHz.}$$

7. The vacuum treatment chamber according to one of claims 1 to 6, **characterized in that** it comprises a generator (2) for the coil (9), a negative feed-back circuit (23, 25) and a measuring arrangement (21) for the plasma density, the measuring arrangement preferably in form of a voltage measuring arrangement at an electrode in the discharge space, preferably at a tool carrier electrode or at a target electrode, the output signal of which being fed as a measured ACTUAL value(X) to the negative feed-back circuit (23, 25), which acts on the generator (2) for the coil (9) as an adjustment element for the plasma density.

**8.** The vacuum treatment chamber according to one of claims 1 to 7, **characterized in that** the screen (13b, c) inside the vacuum treatment chamber (1) separates an outside area (27) from the discharge space (R) and a gas line arrangement (G) exits in the outside area (27).

**9.** A method for surface treatment of workpieces by means of a plasma generated in a vacuum treatment chamber, the plasma being, at least co-generated inductively by means of a coil arrangement, by which method electrically conductive material particles are freed in the plasma, wherein one surrounds the plasma by means of a screen (13b) that is directly exposed to the plasma and located between the plasma and the coil arrangement, the screen comprising slots (17) directed in at least one directional component, axially in relation to the axis of the coil (A), **characterized in that** the slot density S, i.e. number of slots per cm circumference-length of the screen is:

$$1 \ \mathrm{cm}^{-1} \ \leq \ S$$

and that the slots, viewed in direction of the axis of the coil, are tilted ($\varphi$) in relation to the radial direction (r).

**10.** A method according to claim 9, **characterized in that** electrically conductive workpiece surfaces are sputter-etched or workpieces with electrically conductive layers are sputter-coated.

**Revendications**

**1.** Chambre de traitement sous vide (1) pour des pièces, avec au moins une bobine d'induction (9, 9a, 9') au moins pour cogénérer un plasma de traitement dans un espace de décharge (R) situé à l'intérieur de la bobine, et avec un écran fendu (13) qui est exposé directement à l'espace de décharge (R), qui est coaxial par rapport à l'axe de la bobine, qui se trouve entre l'espace de décharge (R) et la bobine (9, 9a, 9') et dont les fentes présentent une composante de direction parallèle à l'axe de bobine (A), étant précisé que l'écran est formé par un corps fermé sur lui-même, **caractérisé en ce que** les fentes sont prévues le long d'au moins la plus grande partie de la circonférence du corps avec une densité de fentes S, c'est-à-dire un nombre de fentes par cm de longueur circonférentielle,

$$1 \ \mathrm{cm}^{-1} \ \leq \ S$$

et **en ce que** les fentes, considérées dans le sens de l'axe de la bobine, sont inclinées ($\varphi$) par rapport au sens radial (r).

**2.** Chambre de traitement sous vide selon la revendication 1, **caractérisée en ce qu'**on a

$$1,5 \ \mathrm{cm}^{-1} \ \leq \ S.$$

**3.** Chambre de traitement sous vide selon l'une des revendications 1 ou 2, **caractérisée en ce que** pour la largeur d des fentes, on a :

$$d \ \leq \ 2 \ \mathrm{mm},$$

de préférence

$$d \ \leq \ 1 \ \mathrm{mm}.$$

**4.** Chambre de traitement sous vide selon l'une des revendications 1 à 3, **caractérisée en ce que** l'écran est fabriqué en métal, et la chambre de traitement sous vide est de préférence conçue pour que l'écran puisse être mis à un potentiel de référence électrique.

**5.** Chambre de traitement sous vide selon l'une des revendications 1 à 4, **caractérisée en ce que** la chambre comprend une paroi coaxiale (3) en matériau diélectrique, et la bobine (9) est disposée à l'intérieur ou à l'extérieur de cette paroi.

**6.** Chambre de traitement sous vide selon l'une des revendications 1 à 5, **caractérisée en ce qu'**il est prévu dans l'espace de décharge (R) au moins une paire d'électrodes espacées, et ce dispositif d'électrodes est relié à

- une source de courant continu (20a) ou à
- une source de courant alternatif (20c) ou à
- une source de courant alternatif+courant continu (20b) ou à
- une source de courant continu pulsé (20b), de préférence à une source haute fréquence ou à une source de courant continu, étant précisé que le plasma de fonctionnement pour le traitement d'outil est apte à être excité aussi bien par la bobine (9), de manière inductive, que par les électrodes (5, 7), de manière capacitive, étant précisé que la bobine d'induction est apte à être excitée de préférence avec un générateur de moyenne fréquence (2) relié à la bobine d'induction, avec une fréquence $f_m$:

$$100 \text{ kHz} < f_m \le 800 \text{ kHz}.$$

7. Chambre de traitement sous vide selon l'une des revendications 1 à 6, **caractérisée en ce qu'**elle contient un générateur (2) pour la bobine (9), un circuit de régulation (23, 25) et un dispositif de mesure (21) pour la densité de plasma, de préférence sous la forme d'un dispositif de mesure de tension sur une électrode dans l'espace de décharge, de préférence sur une électrode de porte-outil ou une électrode cible, dont le signal de sortie est transmis comme valeur réelle mesurée (X) au circuit de régulation (23, 25), lequel agit comme actionneur pour la densité de plasma sur le générateur (2) pour la bobine (9).

8. Chambre de traitement sous vide selon l'une des revendications 1 à 7, **caractérisée en ce que** l'écran (13b, c), dans la chambre de traitement sous vide (1), sépare un espace extérieur (27) et l'espace de décharge (R), et un dispositif de conduit de gaz (G) débouche dans l'espace extérieur (27).

9. Procédé pour le traitement de surface de pièces à l'aide d'un plasma qui est généré dans une chambre de traitement sous vide et qui est au moins cogénéré à l'aide d'un dispositif à bobine de manière inductive, et selon lequel des particules de matériau conductrices d'électricité sont libérées dans le plasma, étant précisé que l'on enferme le plasma à l'aide d'un écran (13b) exposé directement audit plasma et situé entre le plasma et le dispositif à bobine, avec des fentes (17) qui sont dirigées au moins dans une composante de direction axialement par rapport à l'axe de bobine (A),
**caractérisé en ce que** l'on prévoit les fentes avec une densité S, c'est-à-dire un nombre de fentes par cm de longueur circonférentielle de l'écran,

$$1 \text{ cm}^{-1} \le S$$

et **en ce que** l'on prévoit que les fentes, considérées dans le sens de l'axe de la bobine, soient inclinées (φ) par rapport au sens radial (r).

10. Procédé selon la revendication 9, **caractérisé en ce que** les surfaces de pièce conductrices d'électricité sont attaquées par pulvérisation cathodique ou les pièces sont recouvertes de couches conductrices d'électricité par pulvérisation cathodique.

FIG.1

FIG.2

FIG.3

FIG.4

FIG.5

FIG.6

FIG.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0271341 A
- US 5569363 A
- EP 0782172 A
- EP 0801413 A
- US 5234529 A
- JP 7153748 A
- US 5569369 A